# EUROPEAN PATENT SPECIFICATION

(11) **EP 4 307 028 B1**
(45) Date of publication and mention of the grant of the patent: **10.06.2026**
(21) Application number: 23183796.4
(22) Date of filing: 06.07.2023
(51) Int. Cl.: G02B 27/00, G02B 27/01, H05K 1/02, H05K 1/18, F21V 8/00, H05K 1/03, H05K 3/32

(54) **OPTICAL ASSEMBLY WITH MICRO LIGHT EMITTING DIODE (LED) AS EYE-TRACKING NEAR INFRARED (NIR) ILLUMINATION SOURCE**
OPTISCHE ANORDNUNG MIT MIKROLEUCHTDIODE (LED) ALS AUGENVERFOLGUNGS-NAHINFRAROT (NIR)-BELEUCHTUNGSQUELLE
ENSEMBLE OPTIQUE AVEC UNE MICRO-DIODE ÉLECTROLUMINESCENTE (DEL) EN TANT QUE SOURCE D'ÉCLAIRAGE PROCHE INFRAROUGE (NIR) DE SUIVI DE L' IL

(30) Priority: 11.07.2022 US 202217862231
(43) Date of publication of application: 17.01.2024
(73) Proprietor: Meta Platforms Technologies, LLC, Menlo Park, CA 94025 (US)
(72) Inventor: MUTLU, Mehmet, Menlo Park, 94025 (US); WU, Wei, Menlo Park, 94025 (US); BISMUTO, Alfredo, Menlo Park, 94025 (US); ZHANG, Qi, Menlo Park, 94025 (US); YAP, Kuan Pei, Menlo Park, 94025 (US)
(74) Representative: Murgitroyd & Company

(56) References cited:
- US-A1- 2017 255 011
- US-A1- 2019 101 761
- US-A1- 2019 227 309
- US-A1- 2020 004 023
- US-A1- 2020 081 253
- US-A1- 2020 150 425
- US-A1- 2020 203 324
- US-A1- 2020 209 453
- US-B1- 10 852 824

## Description

### TECHNICAL FIELD

This patent application relates generally to optical assemblies using eye-tracking techniques, and more specifically, to systems and methods using a micro light emitting diode as an eye-tracking near infrared (nIR) illumination source.

### BACKGROUND

With recent advances in technology, prevalence and proliferation of content creation and delivery has increased greatly in recent years. In particular, interactive content such as virtual reality (VR) content, augmented reality (AR) content, mixed reality (MR) content, and content within and associated with a real and/or virtual environment (e.g., a "metaverse") has become appealing to consumers.

To facilitate delivery of this and other related content, service providers have endeavored to provide various forms of wearable display systems. One such example may be a head-mounted display (HMD) device, such as a wearable eyewear, a wearable headset, or eyeglasses. In some examples, the head-mounted display (HMD) device may project or direct light to form a first image and a second image, and with these images, to generate "binocular" vision for viewing by a user.

Eye-tracking may be used in some head-mounted display (HMD) devices. It may be important for components of an eye-tracking system to balance any number of system criteria, such as power consumption, size, weight, reliability, ease of manufacture, and cost.

US2020/203324A1 describes an electronic device used for virtual reality (VR), augmented reality (AR), and mixed reality (MR). The device comprises: a first display panel having a first side facing an eye of a user; a second display panel having a first side disposed at a second side of the first display panel; a first optical element disposed at the first display panel to emit one of red (R), green (G), or blue (B) light; a second optical element disposed at the first display panel together with the first optical element and configured to emit another one of the R, G, or B light; and a third optical element disposed at the second display panel to emit the remaining one of the R, the G, and the B light.

US2019/101761A1 describes systems, devices, and methods for embedding a holographic optical element in an eyeglass lens, in particular by forming a world-side portion of the eyeglass lens, forming an eye-side portion of the eyeglass lens, physically coupling the eye-side portion of the eyeglass lens to the HOE with a low-temperature optically clear adhesive ("LT-OCA"), and physically coupling the world-side portion of the eyeglass lens to the HOE with LT-OCA. World-side surface of the world-side lens portion may further comprise a coating layer disposed on world-side surface of the world-side lens portion.

### SUMMARY

According to a first aspect, there is provided an optical assembly, comprising: a substrate; a flexible printed circuit board assembly (PCBA) bonded to the substrate; a plurality of micro light emitting diodes (LEDs) bonded to the substrate; a plurality of electrical conductors laminated in the substrate, wherein the conductors electrically connect the micro light emitting diodes to the printed circuit board assembly; and an optically clear adhesive (OCA) layer adhered to the substrate, wherein the optically clear adhesive (OCA) layer comprises: an anti-reflective layer, and an optical adhesive layer, wherein the anti-reflective layer and the optical adhesive layer are arranged in a stacked configuration.

The substrate may comprise an electrically conductive trace arranged to electrically connect a micro light emitting diode to the printed circuit board assembly. The substrate may comprise a transparent conductive electrode arranged to electrically connect a micro light emitting diode to the printed circuit board assembly. The optical assembly may further comprise a virtual imaging distance lens element characterized by a corrective prescription. The optical assembly may further comprise a waveguide element to reflect an image generated by a display toward an eye of a user. The plurality of micro light emitting diodes (LEDs) may be located in an interior region of the substrate. The optically clear adhesive (OCA) layer may comprise a near infrared (nIR) anti-reflective coating.

According to a second aspect, there is provided a head-mounted display (HMD) device, comprising: a frame; an image sensor mounted on the frame, the image sensor to capture an image representing a physical environment in which the head-mounted display (HMD) device is located; and the optical assembly of the first aspect mounted to the frame.

According to a third aspect, there is provided a method comprising: providing a substrate comprising a plurality of conductors laminated in the substrate; bonding a flexible printed circuit board assembly (PCBA) to the substrate; bonding a plurality of micro light emitting diodes (LEDs) to the substrate; electrically connecting the micro light emitting diodes to the printed circuit board assembly via the conductors; and attaching an optically clear adhesive (OCA) layer to the substrate, the optically clear adhesive (OCA) layer comprising an anti-reflective layer and an optical adhesive layer arranged in a stacked configuration.

The plurality of conductors may comprise at least one of an electrically conductive trace or a transparent conductive electrode. The method may further comprise providing a virtual imaging distance lens element characterized by a corrective prescription. The method may further comprise providing a waveguide element to reflect an image generated by a display toward an eye of a user. The plurality of micro light emitting diodes (LEDs) may be located in an interior region of the substrate. The optically clear adhesive (OCA) layer may comprise a near infrared (nIR) anti-reflective coating.

### BRIEF DESCRIPTION OF DRAWINGS

Features of the present disclosure are illustrated by way of example and not limited in the following figures, in which like numerals indicate like elements. One skilled in the art will readily recognize from the following that alternative examples of the structures and methods illustrated in the figures can be employed without departing from the principles described herein.
Figure 1 illustrates a block diagram of an artificial reality system environment including a near-eye display, according to an example.
Figure 2 illustrates a perspective view of a near-eye display in the form of a head-mounted display (HMD) device, according to an example.
Figure 3 illustrates a perspective view of a near-eye display in the form of a pair of glasses, according to an example.
Figure 4 illustrates a perspective view of an optical assembly with bonded micro light emitting diodes (LEDs), in accordance with various examples.
Figure 5 illustrates a plan view of an optical assembly with bonded micro light emitting diodes, in accordance with various examples.
Figure 6 illustrates an expanded view of an optical assembly with bonded micro light emitting diodes, in accordance with various examples.
Figure 7 illustrates a cross-sectional view of a patterned substrate, an encapsulating material, a thermal debonding film, a protective film, and a glass carrier, according to an example.
Figure 8 illustrates a diagram of an example head-mounted display (HMD) device according to various examples.

### DETAILED DESCRIPTION

For simplicity and illustrative purposes, the present application is described by referring mainly to examples thereof. In the following description, numerous specific details are set forth in order to provide a thorough understanding of the present application. It will be readily apparent, however, that the present application may be practiced without limitation to these specific details. In other instances, some methods and structures readily understood by one of ordinary skill in the art have not been described in detail so as not to unnecessarily obscure the present application. As used herein, the terms "a" and "an" are intended to denote at least one of a particular element, the term "includes" means includes but not limited to, the term "including" means including but not limited to, and the term "based on" means based at least in part on.

Eye-tracking may be used in some head-mounted display (HMD) devices. Some eye-tracking techniques are image-based and use near-infrared (nIR) illumination sources and cameras to track pupil and corneal reflections (e.g., glints). These reflections may be used to determine the direction of the user's gaze. To reduce the gaze error, it may be important to generate enough separated bright glints from inside the spherical region of the cornea close to the pupil center at a variety of possible gaze directions (e.g., ideally, all possible gaze directions).

To promote utility, it is desirable for an eye-tracking system to be able to detect gaze direction accurately for a broad population with a variety of eye shapes, eye sizes, head shapes, and head sizes, as well as different degrees of vision impairment. It is also desirable for an eye-tracking system to detect gaze direction accurately across a variety of use cases or scenarios. It is important for components of an eye-tracking system to balance system design criteria, such as low power consumption, size, weight, reliability, manufacturability, and cost.

Disclosed herein are systems, methods, and apparatuses that use an optical assembly (OSM) with integrated near infrared (nIR) micro light emitting diodes (LEDs) for eye-tracking applications. The optical assembly may be cut into the shape of an eye opening using a laser trimming process. Using near infrared (nIR) micro light emitting diodes for illumination may simplify the architecture of the eye-tracking system and reduce manufacturing costs. In addition, the need to use a laser for eye tracking may be reduced or eliminated.

According to various examples, an eye-tracking system may include an optical assembly with integrated micro light emitting diodes. The optical assembly includes a substrate and a flexible printed circuit board assembly bonded to the substrate. Micro light emitting diodes are also bonded to the substrate. A plurality of electrical conductors are patterned on the substrate. The electrical conductor electrically connect the micro light emitting diodes to the printed circuit board assembly. An optically clear adhesive layer is adhered to the substrate. The optically clear adhesive layer includes an anti-reflective layer and an optical adhesive layer arranged in a stacked configuration. The eye-tracking system may be incorporated into a head-mounted display (HMD) device.

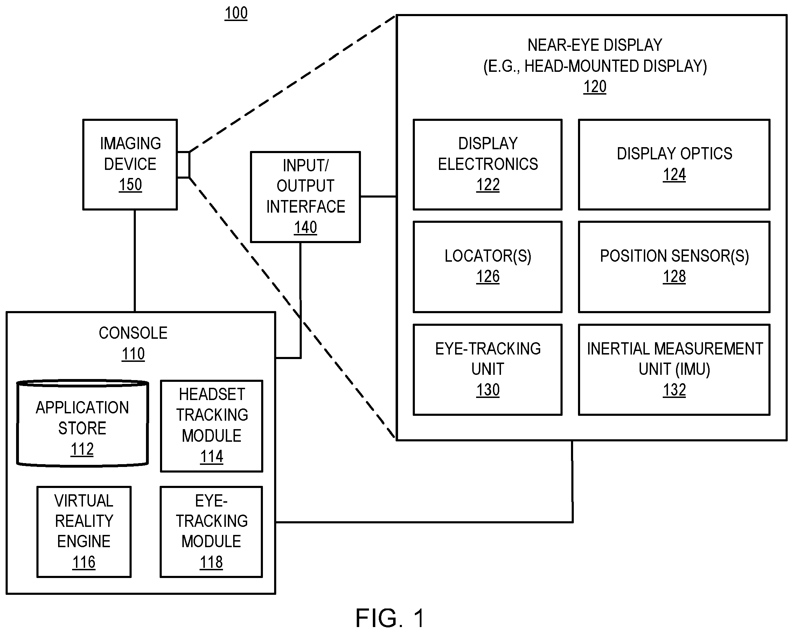

Figure 1 illustrates a block diagram of an artificial reality system environment 100 including a near-eye display, according to an example. As used herein, a "near-eye display" may refer to a device (e.g., an optical device) that may be in close proximity to a user's eye. As used herein, "artificial reality" may refer to aspects of, among other things, a "metaverse" or an environment of real and virtual elements, and may include use of technologies associated with virtual reality (VR), augmented reality (AR), and/or mixed reality (MR). As used herein a "user" may refer to a user or wearer of a "near-eye display."

As shown in Figure 1, the artificial reality system environment 100 may include a near-eye display 120, an optional external imaging device 150, and an optional input/output interface 140, each of which may be coupled to a console 110. The console 110 may be optional in some instances as the functions of the console 110 may be integrated into the near-eye display 120. In some examples, the near-eye display 120 may be a head-mounted display (HMD) that presents content to a user.

In some instances, for a near-eye display system, it may generally be desirable to expand an eye box, reduce display haze, improve image quality (e.g., resolution and contrast), reduce physical size, increase power efficiency, and increase or expand field of view (FOV). As used herein, "field of view" (FOV) may refer to an angular range of an image as seen by a user, which is typically measured in degrees as observed by one eye (for a monocular HMD) or both eyes (for binocular HMDs). Also, as used herein, an "eye box" may be a two-dimensional box that may be positioned in front of the user's eye from which a displayed image from an image source may be viewed.

In some examples, in a near-eye display system, light from a surrounding environment may traverse a "see-through" region of a waveguide display (e.g., a transparent substrate) to reach a user's eyes. For example, in a near-eye display system, light of projected images may be coupled into a transparent substrate of a waveguide, propagate within the waveguide, and be coupled or directed out of the waveguide at one or more locations to replicate exit pupils and expand the eye box.

In some examples, the near-eye display 120 may include one or more rigid bodies, which may be rigidly or non-rigidly coupled to each other. In some examples, a rigid coupling between rigid bodies may cause the coupled rigid bodies to act as a single rigid entity, while in other examples, a non-rigid coupling between rigid bodies may allow the rigid bodies to move relative to each other.

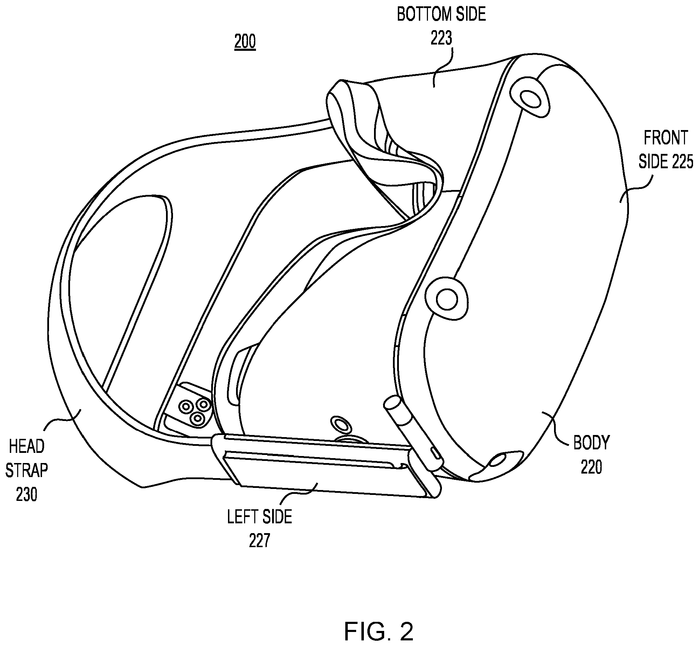

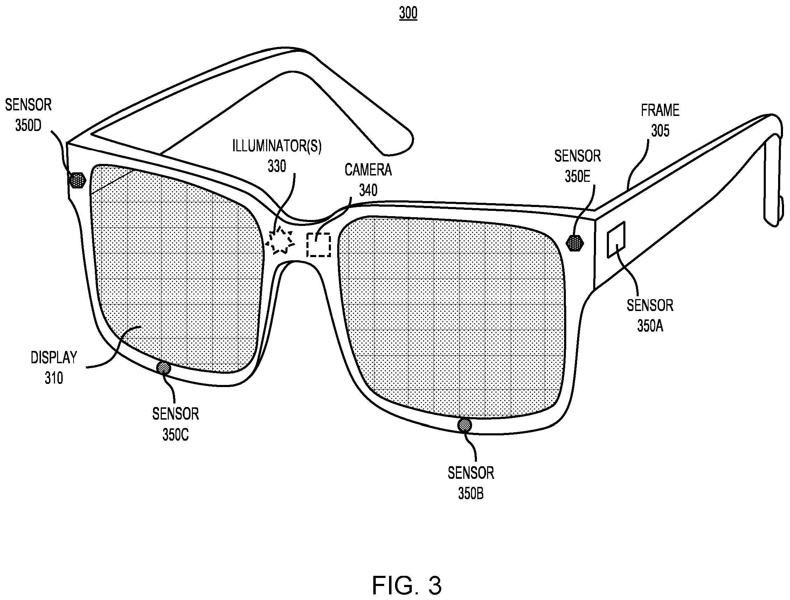

In some examples, the near-eye display 120 may be implemented in any suitable form-factor, including an HMD, a pair of glasses, or other similar wearable eyewear or device. Examples of the near-eye display 120 are further described below with respect to Figures 2 and 3. Additionally, in some examples, the functionality described herein may be used in an HMD or headset that may combine images of an environment external to the near-eye display 120 and artificial reality content (e.g., computer-generated images). Therefore, in some examples, the near-eye display 120 may augment images of a physical, real-world environment external to the near-eye display 120 with generated and/or overlaid digital content (e.g., images, video, sound, etc.) to present an augmented reality to a user.

In some examples, the near-eye display 120 may include any number of display electronics 122, display optics 124, and an eye-tracking unit 130. In some examples, the near eye display 120 may also include one or more locators 126, one or more position sensors 128, and an inertial measurement unit (IMU) 132. In some examples, the near-eye display 120 may omit any of the eye-tracking unit 130, the one or more locators 126, the one or more position sensors 128, and the inertial measurement unit (IMU) 132, or may include additional elements.

In some examples, the display electronics 122 may display or facilitate the display of images to the user according to data received from, for example, the optional console 110. In some examples, the display electronics 122 may include one or more display panels. In some examples, the display electronics 122 may include any number of pixels to emit light of a predominant color such as red, green, blue, white, or yellow. In some examples, the display electronics 122 may display a three-dimensional (3D) image, e.g., using stereoscopic effects produced by two-dimensional panels, to create a subjective perception of image depth.

In some examples, the display optics 124 may display image content optically (e.g., using optical waveguides and/or couplers) or magnify image light received from the display electronics 122, correct optical errors associated with the image light, and/or present the corrected image light to a user of the near-eye display 120. In some examples, the display optics 124 may include a single optical element or any number of combinations of various optical elements as well as mechanical couplings to maintain relative spacing and orientation of the optical elements in the combination. In some examples, one or more optical elements in the display optics 124 may have an optical coating, such as an anti-reflective coating, a reflective coating, a filtering coating, and/or a combination of different optical coatings.

In some examples, the display optics 124 may also be designed to correct one or more types of optical errors, such as two-dimensional optical errors, three-dimensional optical errors, or any combination thereof. Examples of two-dimensional errors may include barrel distortion, pincushion distortion, longitudinal chromatic aberration, and/or transverse chromatic aberration. Examples of three-dimensional errors may include spherical aberration, chromatic aberration field curvature, and astigmatism.

In some examples, the one or more locators 126 may be objects located in specific positions relative to one another and relative to a reference point on the near-eye display 120. In some examples, the optional console 110 may identify the one or more locators 126 in images captured by the optional external imaging device 150 to determine the artificial reality headset's position, orientation, or both. The one or more locators 126 may each be a light-emitting diode (LED), a corner cube reflector, a reflective marker, a type of light source that contrasts with an environment in which the near-eye display 120 operates, or any combination thereof.

In some examples, the external imaging device 150 may include one or more cameras, one or more video cameras, any other device capable of capturing images including the one or more locators 126, or any combination thereof. The optional external imaging device 150 may be configured to detect light emitted or reflected from the one or more locators 126 in a field of view of the optional external imaging device 150.

In some examples, the one or more position sensors 128 may generate one or more measurement signals in response to motion of the near-eye display 120. Examples of the one or more position sensors 128 may include any number of accelerometers, gyroscopes, magnetometers, and/or other motion-detecting or error-correcting sensors, or any combination thereof.

In some examples, the inertial measurement unit (IMU) 132 may be an electronic device that generates fast calibration data based on measurement signals received from the one or more position sensors 128. The one or more position sensors 128 may be located external to the inertial measurement unit (IMU) 132, internal to the inertial measurement unit (IMU) 132, or any combination thereof. Based on the one or more measurement signals from the one or more position sensors 128, the inertial measurement unit (IMU) 132 may generate fast calibration data indicating an estimated position of the near-eye display 120 that may be relative to an initial position of the near-eye display 120. For example, the inertial measurement unit (IMU) 132 may integrate measurement signals received from accelerometers over time to estimate a velocity vector and integrate the velocity vector over time to determine an estimated position of a reference point on the near-eye display 120. Alternatively, the inertial measurement unit (IMU) 132 may provide the sampled measurement signals to the optional console 110, which may determine the fast calibration data.

The eye-tracking unit 130 may include one or more eye-tracking systems. As used herein, "eye tracking" may refer to determining an eye's position or relative position, including orientation, location, and/or gaze of a user's eye. In some examples, an eye-tracking system may include an imaging system that captures one or more images of an eye and may optionally include a light emitter, which may generate light that is directed to an eye such that light reflected by the eye may be captured by the imaging system. In other examples, the eye-tracking unit 130 may capture reflected radio waves emitted by a miniature radar unit. These data associated with the eye may be used to determine or predict eye position, orientation, movement, location, and/or gaze.

In some examples, the near-eye display 120 may use the orientation of the eye to introduce depth cues (e.g., blur image outside of the user's main line of sight), collect heuristics on the user interaction in the virtual reality (VR) media (e.g., time spent on any particular subject, object, or frame as a function of exposed stimuli), some other functions that are based in part on the orientation of at least one of the user's eyes, or any combination thereof. In some examples, because the orientation may be determined for both eyes of the user, the eye-tracking unit 130 may be able to determine where the user is looking or predict any user patterns, etc.

In some examples, the input/output interface 140 may be a device that allows a user to send action requests to the optional console 110. As used herein, an "action request" may be a request to perform a particular action. For example, an action request may be to start or to end an application or to perform a particular action within the application. The input/output interface 140 may include one or more input devices. Example input devices may include a keyboard, a mouse, a game controller, a glove, a button, a touch screen, or any other suitable device for receiving action requests and communicating the received action requests to the optional console 110. In some examples, an action request received by the input/output interface 140 may be communicated to the optional console 110, which may perform an action corresponding to the requested action.

In some examples, the optional console 110 may provide content to the near-eye display 120 for presentation to the user in accordance with information received from one or more of external imaging device 150, the near-eye display 120, and the input/output interface 140. For example, in the example shown in Figure 1, the optional console 110 may include an application store 112, a headset tracking module 114, a virtual reality engine 116, and an eye-tracking module 118. Some examples of the optional console 110 may include different or additional modules than those described in conjunction with Figure 1. Functions further described below may be distributed among components of the optional console 110 in a different manner than is described here.

In some examples, the optional console 110 may include a processor and a non-transitory computer-readable storage medium storing instructions executable by the processor. The processor may include multiple processing units executing instructions in parallel. The non-transitory computer-readable storage medium may be any memory, such as a hard disk drive, a removable memory, or a solid-state drive (e.g., flash memory or dynamic random access memory (DRAM)). In some examples, the modules of the optional console 110 described in conjunction with Figure 1 may be encoded as instructions in the non-transitory computer-readable storage medium that, when executed by the processor, cause the processor to perform the functions further described below. It should be appreciated that the optional console 110 may or may not be needed or the optional console 110 may be integrated with or separate from the near-eye display 120.

In some examples, the application store 112 may store one or more applications for execution by the optional console 110. An application may include a group of instructions that, when executed by a processor, generates content for presentation to the user. Examples of the applications may include gaming applications, conferencing applications, video playback application, or other suitable applications.

In some examples, the headset tracking module 114 may track movements of the near-eye display 120 using slow calibration information from the external imaging device 150. For example, the headset tracking module 114 may determine positions of a reference point of the near-eye display 120 using observed locators from the slow calibration information and a model of the near-eye display 120. Additionally, in some examples, the headset tracking module 114 may use portions of the fast calibration information, the slow calibration information, or any combination thereof, to predict a future location of the near-eye display 120. In some examples, the headset tracking module 114 may provide the estimated or predicted future position of the near-eye display 120 to the virtual reality engine 116.

In some examples, the virtual reality engine 116 may execute applications within the artificial reality system environment 100 and receive position information of the near-eye display 120, acceleration information of the near-eye display 120, velocity information of the near-eye display 120, predicted future positions of the near-eye display 120, or any combination thereof from the headset tracking module 114. In some examples, the virtual reality engine 116 may also receive estimated eye position and orientation information from the eye-tracking module 118. Based on the received information, the virtual reality engine 116 may determine content to provide to the near-eye display 120 for presentation to the user.

In some examples, the eye-tracking module 118 may receive eye-tracking data from the eye-tracking unit 130 and determine the position of the user's eye based on the eye tracking data. In some examples, the position of the eye may include an eye's orientation, location, or both relative to the near-eye display 120 or any element thereof. So, in these examples, because the eye's axes of rotation change as a function of the eye's location in its socket, determining the eye's location in its socket may allow the eye-tracking module 118 to more accurately determine the eye's orientation.

In some examples, a location of a projector of a display system may be adjusted to enable any number of design modifications. For example, in some instances, a projector may be located in front of a viewer's eye (i.e., "front-mounted" placement). In a front-mounted placement, in some examples, a projector of a display system may be located away from a user's eyes (i.e., "world-side"). In some examples, a head-mounted display (HMD) device may utilize a front-mounted placement to propagate light towards a user's eye(s) to project an image.

Figure 2 illustrates a perspective view of a near-eye display in the form of a head-mounted display (HMD) device 200, according to an example. In some examples, the HMD device 200 may be a part of a virtual reality (VR) system, an augmented reality (AR) system, a mixed reality (MR) system, another system that uses displays or wearables, or any combination thereof. In some examples, the HMD device 200 may include a body 220 and a head strap 230. Figure 2 shows a bottom side 223, a front side 225, and a left side 227 of the body 220 in the perspective view. In some examples, the head strap 230 may have an adjustable or extendible length. In particular, in some examples, there may be a sufficient space between the body 220 and the head strap 230 of the HMD device 200 for allowing a user to mount the HMD device 200 onto the user's head. For example, the length of the head strap 230 may be adjustable to accommodate a range of user head sizes. In some examples, the HMD device 200 may include additional, fewer, and/or different components.

In some examples, the HMD device 200 may present, to a user, media or other digital content including virtual and/or augmented views of a physical, real-world environment with computer-generated elements. Examples of the media or digital content presented by the HMD device 200 may include images (e.g., two-dimensional (2D) or three-dimensional (3D) images), videos (e.g., 2D or 3D videos), audio, or any combination thereof. In some examples, the images and videos may be presented to each eye of a user by one or more display assemblies (not shown in Figure 2) enclosed in the body 220 of the HMD device 200.

In some examples, the HMD device 200 may include various sensors (not shown), such as depth sensors, motion sensors, position sensors, and/or eye tracking sensors. Some of these sensors may use any number of structured or unstructured light patterns for sensing purposes. In some examples, the HMD device 200 may include an input/output interface 140 for communicating with a console 110, as described with respect to Figure 1. In some examples, the HMD device 200 may include a virtual reality engine (not shown), but similar to the virtual reality engine 116 described with respect to Figure 1, that may execute applications within the HMD device 200 and receive depth information, position information, acceleration information, velocity information, predicted future positions, or any combination thereof of the HMD device 200 from the various sensors.

In some examples, the information received by the virtual reality engine 116 may be used for producing a signal (e.g., display instructions) to the one or more display assemblies. In some examples, the HMD device 200 may include locators (not shown), but similar to the virtual locators 126 described in Figure 1, which may be located in fixed positions on the body 220 of the HMD device 200 relative to one another and relative to a reference point. Each of the locators may emit light that is detectable by an external imaging device. This may be useful for the purposes of head tracking or other movement/orientation. It should be appreciated that other elements or components may also be used in addition or in lieu of such locators.

It should be appreciated that in some examples, a projector mounted in a display system may be placed near and/or closer to a user's eye (i.e., "eye-side"). In some examples, and as discussed herein, a projector for a display system shaped liked eyeglasses may be mounted or positioned in a temple arm (i.e., a top far corner of a lens side) of the eyeglasses. It should be appreciated that, in some instances, utilizing a back-mounted projector placement may help to reduce size or bulkiness of any required housing required for a display system, which may also result in a significant improvement in user experience for a user.

Figure 3 is a perspective view of a near-eye display 300 in the form of a pair of glasses (or other similar eyewear), according to an example. In some examples, the near-eye display 300 may be a specific example of near-eye display 120 of Figure 1, and may be configured to operate as a virtual reality display, an augmented reality display, and/or a mixed reality display.

In some examples, the near-eye display 300 may include a frame 305 and a display 310. In some examples, the display 310 may be configured to present media or other content to a user. In some examples, the display 310 may include display electronics and/or display optics, similar to components described with respect to Figures 1-2. For example, as described above with respect to the near-eye display 120 of Figure 1, the display 310 may include a liquid crystal display (LCD) display panel, a light-emitting diode (LED) display panel, or an optical display panel (e.g., a waveguide display assembly). In some examples, the display 310 may also include any number of optical components, such as waveguides, gratings, lenses, mirrors, etc.

In some examples, the near-eye display 300 may further include various sensors 350a, 350b, 350c, 350d, and 350e on or within a frame 305. In some examples, the various sensors 350a-350e may include any number of depth sensors, motion sensors, position sensors, inertial sensors, and/or ambient light sensors, as shown. In some examples, the various sensors 350a-350e may include any number of image sensors configured to generate image data representing different fields of views in one or more different directions. In some examples, the various sensors 350a-350e may be used as input devices to control or influence the displayed content of the near-eye display 300, and/or to provide an interactive virtual reality (VR), augmented reality (AR), and/or mixed reality (MR) experience to a user of the near-eye display 300. In some examples, the various sensors 350a-350e may also be used for stereoscopic imaging or other similar application.

In some examples, the near-eye display 300 may further include one or more illuminators 330 to project light into a physical environment. The projected light may be associated with different frequency bands (e.g., visible light, infra-red light, ultraviolet light, etc.), and may serve various purposes. In some examples, the one or more illuminator(s) 330 may be used as locators, such as the one or more locators 126 described above with respect to Figures 1-2.

In some examples, the near-eye display 300 may also include a camera 340 or other image capture unit. The camera 340, for instance, may capture images of the physical environment in the field of view. In some instances, the captured images may be processed, for example, by a virtual reality engine (e.g., the virtual reality engine 116 of Figure 1) to add virtual objects to the captured images or modify physical objects in the captured images, and the processed images may be displayed to the user by the display 310 for augmented reality (AR) and/or mixed reality (MR) applications.

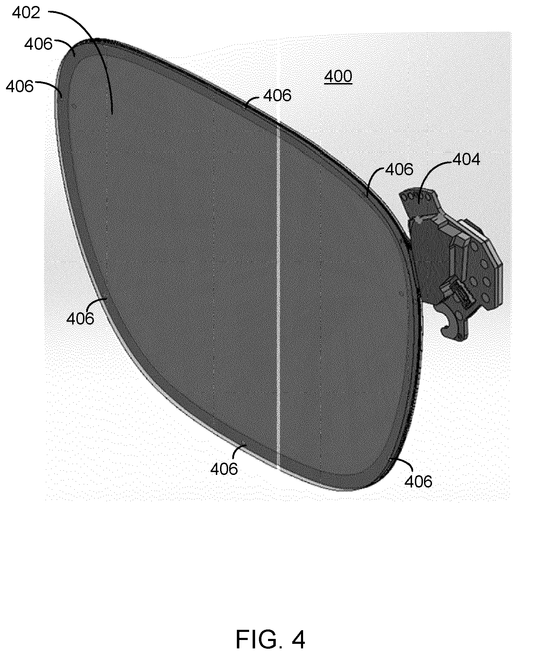

Figure 4 illustrates a perspective view of an optical assembly 400 with bonded micro light emitting diodes, in accordance with various examples. In some examples, other illumination sources may be used. For example, lasers, such as vertical cavity surface emitting lasers (VCSELs) may be used as illumination sources. VCSELs coupled with photonic integrated waveguides may be used as illumination sources. The optical assembly 400 may be integrated as part of a head-mounted display (HMD) device, such as the near-eye display 300 of Figure 3. In some examples, the optical assembly 400 may include an L1 layer 402. The L1 layer 402 may be implemented as a rigid, transparent substrate that provides a mechanical support for a flexible film substrate with light emitting diodes (LEDs) or other illumination sources. The L1 layer 402 may be formed from glass or another suitable material. In some examples, the L1 layer 402, which may also be referred to as a virtual image distance (VID) layer, may control a perceived distance of a displayed image. For example, by controlling the phase of light passing through the L1 layer 402 that is associated with a displayed image, the L1 layer 402 may cause the image to appear in front of or behind objects in a physical environment.

In some examples, the optical assembly 400 includes a printed circuit board assembly (PCBA) 404. The printed circuit board assembly 404 may provide an interface between the optical assembly 400 and other components of the head-mounted display (HMD) device. For example, the printed circuit board assembly 404 may communicate data and/or control signals between the optical assembly 400 and other components, such as control circuitry. As another example, the printed circuit board assembly 404 may conduct power from a power source, such as a battery, to the optical assembly 400.

In some examples, the printed circuit board assembly 404 is bonded to a substrate. For example, anisotropic conductive bonding (ACF), wire bonding, or other suitable techniques may be used to connect the printed circuit board assembly 404 to the conductive patterns on the substrate. Anisotropic conductive bonding, for example, may be used to connect illumination or display circuit patterns to a printed circuit board using anisotropic conductive adhesive and flex coils. This may provide a low-cost manufacturing process to interconnect multiple dense conductive traces. Anisotropic conductive bonding may enable electrical conductivity in one direction (e.g., vertical), but not another (e.g., lateral) after the high pressure and temperature process is completed. The substrate may be formed from a transparent material, such as glass, transparent polyimide, polyethylene terephthalate (PET), PEN, polycarbonate, cyclo-olefin polymer (COP), PMMA, polyvinyl chloride (PVC), and the like. The printed circuit board assembly 404 may be bonded to the substrate using anisotropic conductive film.

In some examples, micro light emitting diodes (LEDs) 406 (e.g., more than six micro LEDs) are bonded onto the substrate. For example, as illustrated in Figure 4, the micro light emitting diodes 406 may be located around the perimeter of the substrate. The micro light emitting diodes 406 may have dimensions (e.g., length and/or width) less than 250 µm. In some examples, the micro light emitting diodes 406 may have a peak wavelength output in the range of 930 nm to 950 nm, with a spectral width (full width at half maximum (FWHM)) of 20-50 nm. The micro light emitting diodes 406 may have a radiant flux greater than 2 mW with an emission cone angle greater than 60° and a wall plug efficiency (WPE) greater than 5%.

The micro light emitting diodes 406 are electrically connected to the printed circuit board assembly 404 via electrical conductors. For example, conductive (e.g., copper) wires are laminated or otherwise integrated in the substrate. In some examples, a thin (e.g., 1-2 microns) seed layer including nickel and/or copper may be deposited via a plating or vacuum sputtering process. A modified semi-additive process (mSAP) may be used to pattern and coat a thicker (e.g., 10-20 microns) copper layer and a protective metal layer on the seed layer. The protective layer may include, for example, nickel, palladium, and/or gold layers, each of which may be 0.5-2 microns thick. A rigid glass layer with a thermal debonding film (TDF) layer may be applied on the back of the flexible printed circuit board assembly 404 for further steps of applying the micro light emitting diodes 406 via a bonding process, cutting eye shapes, and/or laminating printed circuit board connectors to connect the conductive traces. In some examples, transparent conductive electrodes may electrically connect the micro light emitting diodes 406 to the printed circuit board assembly 404. The transparent conductive electrodes may be sputtered onto a substrate and then patterned into isolated conductive traces. The conductive electrodes may be formed from indium doped tin oxide, aluminum doped zinc oxide, silver nanowires, nano-fiber meshes and/or polymeric materials with metal conductive traces, for example. As another example, the conductive electrodes may be formed from copper mesh lines comprising small copper lines separated by gaps. In some examples, the micro light emitting diodes and/or conductive traces may be encapsulated by an adhesive and/or another material. This material may also seal the edge of the optical assembly 400.

In some examples, an optically clear adhesive (OCA) layer may be located between the L1 layer 402 and the substrate. The optically clear adhesive layer includes a stack of anti-reflective layers and optical adhesive layers, e.g., arranged in an interleaved configuration. The stack of anti-reflective layers and optical adhesive layers may enable a total optical transmission exceeding 90% in the visible spectrum. In some examples, a side of the optically clear adhesive layer that faces the user's eye may have an anti-reflective coating that is characterized by a reflection of less than 10% at all angles of incidence less than 60°. In some examples, the optically clear adhesive layer may reduce the appearance of artifacts in the displayed image.

In some examples, a virtual imaging distance (VID1) lens element may be located on a side of the optical assembly 400 that faces the user's eye. The virtual imaging distance lens element may add a refractive power to adjust the perceived distance of a displayed image, for example, to accommodate users who use a head-mounted display (HMD) device with corrective lenses. For example, the L1 layer 402 on the world side may include a refractive power of, e.g., - 0.65 diopter, which will bring the virtual image distance to, e.g., 1.5 m to provide high visual acuity for users. To correct the virtual imaging distance effect on the world side, another virtual imaging distance (e.g., VID1) layer having a refractive power of, e.g., -0.65 diopter may be included to compensate for the refractive power of the L1 layer 402. For users with myopia, then in addition to the -0.65 diopter with the L1 layer 402, an extra optical power may be integrated with the VID1 layer. The strength of the optical power may depend on the user's prescription.

In some examples, the optical assembly 400 may include one or more waveguide elements to direct a displayed image toward the user's eyes. The waveguide elements may be implemented in a layer located, for example, inward from a second virtual imaging distance (VID2) lens element, described herein.

In some examples, the optical assembly 400 may include a second virtual imaging distance (VID2) lens element. The second virtual imaging distance (VID2) lens element may be located on a world-facing side of the optical assembly 400. In some examples, the second virtual imaging distance (VID2) lens element has a refractive power, e.g., to compensate for a virtual imaging distance change introduced by another virtual imaging distance lens element. For example, the second virtual imaging distance lens element may have a spherical refractive power of +0.65 diopter. This may allow the user to see through the optical assembly correctly. In some examples, the second virtual imaging distance (VID2) lens element may provide variable visible transmission in the presence of ambient light to control the display contrast. This may facilitate use of the optical assembly 400 in both indoor and outdoor environments, e.g., with a dimmer. The second virtual imaging distance (VID2) lens element may be able to selectively control the amount of light that is passed through from the outside environment to promote consistency of the display contrast. In some examples, the second virtual imaging distance (VID2) lens element provides protection against environmental pollution, damage, and wear and tear associated with usage.

In some examples, the optical assembly 400 may include a holographic optical element (HOE). The holographic optical element may diffract near infrared (nIR) light from the eye reflection (e.g., glint) toward an optical sensor. Using the holographic optical element may result in faster stereo view calibration for eye-tracking, as well as faster eye-tracking authentication.

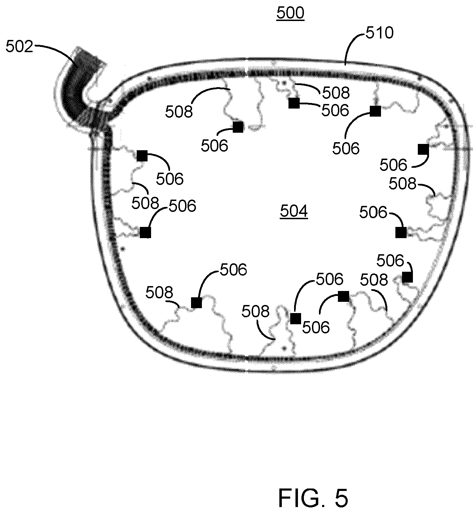

Figure 5 illustrates a plan view of an optical assembly 500 with bonded micro light emitting diodes, in accordance with various examples. The optical assembly 500 includes a printed circuit board assembly (PCBA) 502 that provides an interface between the optical assembly 500 and other components of the head-mounted display (HMD) device. For example, the printed circuit board assembly 502 may communicate data and/or control signals between the optical assembly 500 and other components, such as control circuitry. As another example, the printed circuit board assembly 502 may conduct power from a power source, such as a battery, to the optical assembly 500.

In some examples, the printed circuit board assembly 502 is bonded to a patterned substrate 504. The patterned substrate 504 may be formed from a transparent material, such as glass, transparent polyimide, polyethylene terephthalate (PET), PEN, polycarbonate, cyclo-olefin polymer (COP), PMMA, polyvinyl chloride (PVC), and the like. In some examples, the patterned substrate 504 includes electrical conductors, e.g., conductive traces or smaller conductors, arranged on the surface or under the surface to form a pattern. The printed circuit board assembly 502 may be bonded to the patterned substrate 504 using anisotropic conductive film.

In some examples, micro light emitting diodes (LEDs) 506 (e.g., more than six micro LEDs) are bonded onto the patterned substrate 504. As illustrated in Figure 5, the micro light emitting diodes 506 may be located in an interior region of the patterned substrate 504. Locating the micro light emitting diodes 506 in an interior region of the patterned substrate 504 may provide more uniform illumination in the eye box. As a result, when a strong refractive power is integrated for vision correction, illumination may be more uniform. In addition, shorter eye-relief distances may be realized because the light from the micro light emitting diodes 506 may travel a shorter distance to the user's eye. The micro light emitting diodes 506 may have dimensions (e.g., length and/or width) less than 250 µm. In some examples, the micro light emitting diodes 506 may have a peak wavelength output in the range of 930 nm to 950 nm, with a spectral width (full with at half maximum (FWHM)) of 20-50 nm. The micro light emitting diodes 506 may have a radiant flux greater than 2 mW with an emission cone angle greater than 60° and a wall plug efficiency (WPE) greater than 5%.

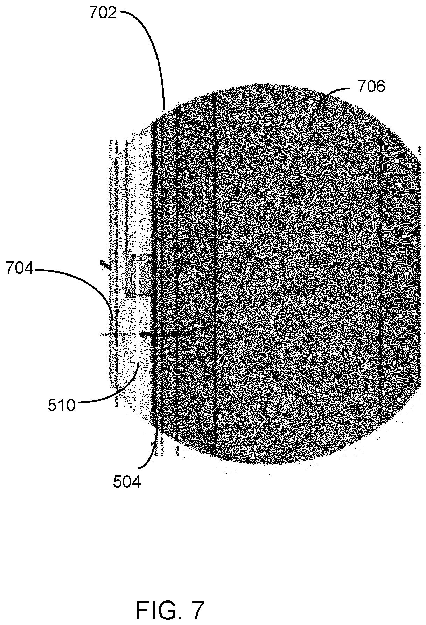

The micro light emitting diodes 506 are electrically connected to the printed circuit board assembly 502 via electrical conductors 508. For example, conductive (e.g., copper) wires are laminated or otherwise integrated in the substrate. In some examples, a thin (e.g., 1-2 microns) seed layer including nickel and/or copper may be deposited via a plating or vacuum sputtering process. A modified semi-additive process (mSAP) may be used to pattern and coat a thicker (e.g., 10-20 microns) copper layer and a protective metal layer on the seed layer. The protective layer may include, for example, nickel, palladium, and/or gold layers, each of which may be 0.5-2 microns thick. A rigid glass layer with a thermal debonding film (TDF) layer may be applied on the back of the printed circuit board assembly 502 for further steps of applying the micro light emitting diodes 506 via a bonding process, cutting eye shapes, and/or laminating printed circuit board connectors to connect the conductive traces. In some examples, transparent conductive electrodes may electrically connect the micro light emitting diodes 506 to the printed circuit board assembly 502. The transparent conductive electrodes may be sputtered onto a substrate and then patterned into isolated conductive traces. The conductive electrodes may be formed from indium doped tin oxide, aluminum doped zinc oxide, silver nanowires, nano-fiber meshes and/or polymeric materials with metal conductive traces, for example. As another example, the conductive electrodes may be formed from copper mesh lines comprising small copper lines separated by gaps. In some examples, the micro light emitting diodes and/or conductive traces may be encapsulated by an adhesive and/or another encapsulating material 510. This encapsulating material 510 may also seal the edge of the optical assembly 500. Figure 7 illustrates a cross sectional view of the patterned substrate 504, the encapsulating material 510, a thermal debonding film 702, a protective film 704, and a glass carrier 706. The glass carrier 706 may be removed after the optical assembly 500 has been manufactured.

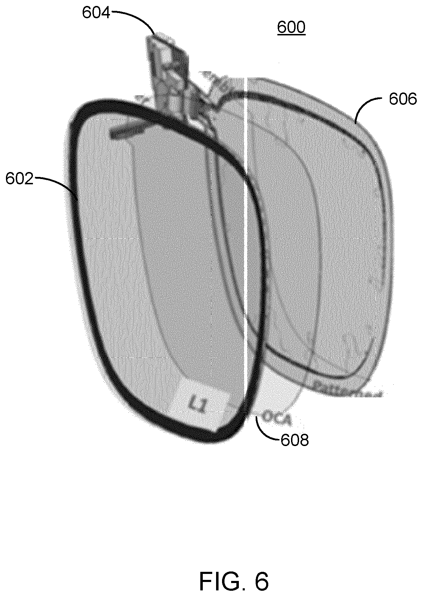

Figure 6 illustrates an expanded view of an optical assembly 600 with bonded micro light emitting diodes, in accordance with various examples. In some examples, other illumination sources may be used. For example, lasers, such as vertical cavity surface emitting lasers (VCSELs) may be used as illumination sources. VCSELs coupled with photonic integrated waveguides may be used as illumination sources. The optical assembly 600 may be integrated as part of a head-mounted display (HMD) device, such as the near-eye display 300 of Figure 3. In some examples, the optical assembly 600 may include an L1 layer 602. The L1 layer 602 may be implemented as a rigid, transparent substrate that provides a mechanical support for a flexible film substrate with light emitting diodes (LEDs) or other illumination sources. The L1 layer 602 may be formed from glass or another suitable material. In some examples, the L1 layer 602, which may also be referred to as a virtual image distance (VID) layer, may control a perceived distance of a displayed image. For example, by controlling the phase of light passing through the L1 layer 602 that is associated with a displayed image, the L1 layer 602 may cause the image to appear in front of or behind objects in a physical environment.

In some examples, the optical assembly 600 includes a printed circuit board assembly (PCBA) 604. The printed circuit board assembly 604 may provide an interface between the optical assembly 600 and other components of the head-mounted display (HMD) device. For example, the printed circuit board assembly 604 may communicate data and/or control signals between the optical assembly 600 and other components, such as control circuitry. As another example, the printed circuit board assembly 604 may conduct power from a power source, such as a battery, to the optical assembly 600.

In some examples, the printed circuit board assembly 604 is bonded to a substrate 606. The substrate 606 may be formed from a transparent material, such as glass, transparent polyimide, polyethylene terephthalate (PET), PEN, polycarbonate, cyclo-olefin polymer (COP), PMMA, polyvinyl chloride (PVC, and the like. The printed circuit board assembly 604 may be bonded to the substrate 606 using anisotropic conductive film.

In some examples, micro light emitting diodes (LEDs) (e.g., more than six micro LEDs) are bonded onto the substrate 606. The micro light emitting diodes may have dimensions (e.g., length and/or width) less than 250 µm. In some examples, the micro light emitting diodes may have a peak wavelength output in the range of 930 nm to 950 nm, with a spectral width (full with at half maximum (FWHM)) of 20-50 nm. The micro light emitting diodes may have a radiant flux greater than 2 mW with an emission cone angle greater than 60° and a wall plug efficiency (WPE) greater than 5%.

The micro light emitting diodes are electrically connected to the printed circuit board assembly 604 via electrical conductors. For example, conductive (e.g., copper) wires are laminated or otherwise integrated in the substrate 606. In some examples, transparent conductive electrodes may electrically connect the micro light emitting diodes to the printed circuit board assembly 604. In some examples, a thin (e.g., 1-2 microns) seed layer including nickel and/or copper may be deposited via a plating or vacuum sputtering process. A modified semi-additive process (mSAP) may be used to pattern and coat a thicker (e.g., 10-20 microns) copper layer and a protective metal layer on the seed layer. The protective layer may include, for example, nickel, palladium, and/or gold layers, each of which may be 0.5-2 microns thick. A rigid glass layer with a thermal debonding film (TDF) layer may be applied on the back of the flexible printed circuit board assembly 604 for further steps of applying the micro light emitting diodes via a bonding process, cutting eye shapes, and/or laminating printed circuit board connectors to connect the conductive traces. The conductive electrodes may be formed from indium doped tin oxide, aluminum doped zinc oxide, silver nanowires, nano-fiber meshes and/or polymeric materials with metal conductive traces, for example. As another example, the conductive electrodes may be formed from copper mesh lines comprising small copper lines separated by gaps. In some examples, the micro light emitting diodes and/or conductive traces may be encapsulated by an adhesive and/or another material. This material may also seal the edge of the optical assembly 600.

In some examples, an optically clear adhesive (OCA) layer 608 may be located between the L1 layer 602 and the substrate 606. The optically clear adhesive layer 608 includes a stack of anti-reflective layers and optical adhesive layers. The stack of layers may enable a total optical transmission exceeding 90% in the visible spectrum. In some examples, a side of the optically clear adhesive layer 608 that faces the user's eye may have an anti-reflective coating that is characterized by a reflection of less than 10% at all angles of incidence less than 60°. In some examples, the optically clear adhesive layer 608 may reduce the appearance of artifacts in the displayed image.

In some examples, a virtual imaging distance (VID1) lens element may be located on a side of the optical assembly 600 that faces the user's eye. The virtual imaging distance lens element may add a refractive power to adjust the perceived distance of a displayed image, for example, to accommodate users who use a head-mounted display (HMD) device with corrective lenses. For example, the L1 layer 602 on the world side may include a refractive power of, e.g., - 0.65 diopter, which will bring the virtual image distance to, e.g., 1.5 m to provide high visual acuity for users. To correct the virtual imaging distance effect on the world side, another virtual imaging distance (e.g., VID1) layer having a refractive power of, e.g., +0.65 diopter may be included to compensate for the refractive power of the L1 layer 602. For users with myopia, then in addition to the -0.65 diopter with the L1 layer 602, an extra optical power may be integrated with the VID1 layer. The strength of the optical power may depend on the user's prescription.

In some examples, the optical assembly 600 may include one or more waveguide elements to direct a displayed image toward the user's eyes. The waveguide elements may be implemented in a layer located, for example, inward from a second virtual imaging distance (VID2) lens element, described herein.

In some examples, the optical assembly 600 may include a second virtual imaging distance (VID2) lens element having a refractive power. The second virtual imaging distance (VID2) lens element may be located on a world-facing side of the optical assembly 600. In some examples, the second virtual imaging distance (VID2) lens element may have a refractive power, e.g., to compensate for a virtual imaging distance change introduced by another virtual imaging distance lens element. For example, the second virtual imaging distance lens element may have a spherical refractive power of +0.65 diopter. This may allow the user to see through the optical assembly correctly. In some examples, the second virtual imaging distance (VID2) lens element may provide variable visible transmission in the presence of ambient light to control the display contrast. This may facilitate use of the optical assembly 600 in both indoor and outdoor environments, e.g., with a dimmer. The second virtual imaging distance (VID2) lens element may be able to selectively control the amount of light that is passed through from the outside environment to promote consistency of the display contrast. In some examples, the second virtual imaging distance (VID2) lens element provides protection against environmental pollution, damage, and wear and tear associated with usage. For

In some examples, the optical assembly 600 may include a holographic optical element (HOE). The holographic optical element may diffract near infrared (nIR) light from the eye reflection (e.g., glint) toward an optical sensor. Using the holographic optical element may result in faster stereo view calibration for eye-tracking, as well as faster eye-tracking authentication.

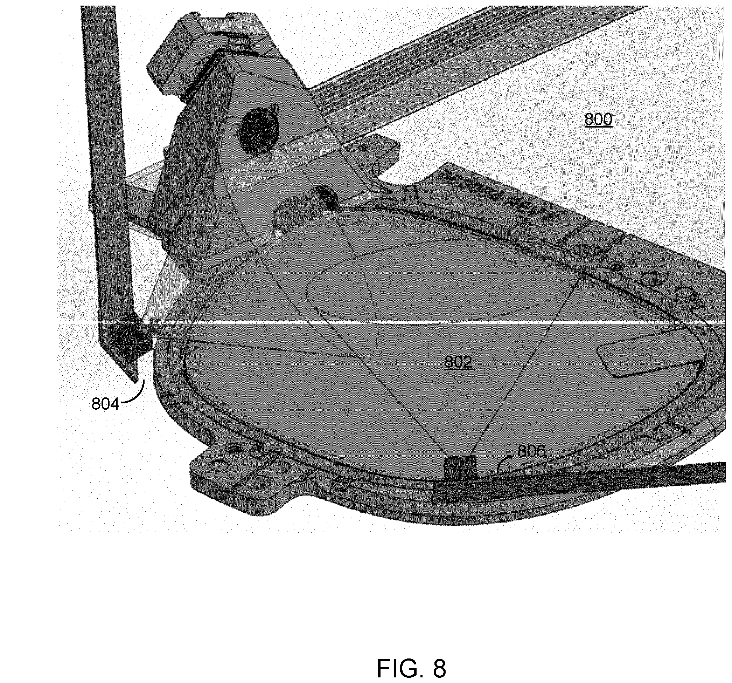

In some examples, an optical assembly may be incorporated into a head-mounted display (HMD) device. Figure 8 illustrates a diagram of an example head-mounted display (HMD) device 800 according to various examples. The head-mounted display (HMD) device 800 may include an optical assembly (OSM) 802 as described herein. In some examples, the optical assembly 802 includes integrated near infrared (nIR) micro light emitting diodes (LEDs) as illumination sources. Additional near infrared (nIR) micro light emitting diodes (LEDs) may be located on a tapering edge of the frame and may be oriented to point toward the rotational center of the user's eyeball as additional illumination sources.

In some examples, the head-mounted display (HMD) device 800 includes direct-view camera modules 804, 806 mounted on a frame 808 of the head-mounted display (HMD) device 800. The direct-view camera modules 804, 806 are positioned to capture images of the user's eyes when the eyes are illuminated by the near infrared (nIR) micro light emitting diodes (LEDs). Reflections (e.g., glints) in the images may be used to determine a direction of a gaze of the user.

In some examples, the direct-view camera modules 804, 806 may be operable at least at the wavelength range between 800 nm and 965 nm with a 50% cutoff. The dimensions of the direct-view camera modules 804, 806 may be less than 3 mm by 3 mm to ensure that the direct-view camera modules 804, 806 are properly sized for the frame of the head-mounted display (HMD) device 800. The frame may be tapered on its edge to facilitate placement of the direct-view camera modules 804, 806 at an angle in the range of approximately 10° to 80°.

In some examples, the working distance of the direct-view camera modules 804, 806 may be between 13 mm and 42 mm. The diagonal field of view of the direct-view camera modules 804, 806 may be at least 60°. In some examples, the direct-view camera modules 804, 806 may have a resolution of at least 1 pixel per mm at the object plane.

In the foregoing description, various examples are described, including devices, systems, methods, and the like. For the purposes of explanation, specific details are set forth in order to provide a thorough understanding of examples of the disclosure. However, it will be apparent that various examples may be practiced without these specific details. For example, devices, systems, structures, assemblies, methods, and other components may be shown as components in block diagram form in order not to obscure the examples in unnecessary detail. In other instances, well-known devices, processes, systems, structures, and techniques may be shown without necessary detail in order to avoid obscuring the examples.

The figures and description are not intended to be restrictive. The terms and expressions that have been employed in this disclosure are used as terms of description and not of limitation, and there is no intention in the use of such terms and expressions of excluding any equivalents of the features shown and described or portions thereof. The word "example" is used herein to mean "serving as an example, instance, or illustration." Any embodiment or design described herein as "example' is not necessarily to be construed as preferred or advantageous over other embodiments or designs.

Although the methods and systems as described herein may be directed mainly to digital content, such as videos or interactive media, it should be appreciated that the methods and systems as described herein may be used for other types of content or scenarios as well. Other applications or uses of the methods and systems as described herein may also include social networking, marketing, content-based recommendation engines, and/or other types of knowledge or data-driven systems.

## Claims

1. An optical assembly (400, 500, 600), comprising:
a substrate (504, 606);
a flexible printed circuit board assembly, PCBA (404, 502, 604) bonded to the substrate (504, 606);
a plurality of micro light emitting diodes, LEDs (406, 506) bonded to the substrate (504, 606);
a plurality of electrical conductors laminated in the substrate (504, 606), wherein the conductors electrically connect the micro light emitting diodes (406, 506) to the printed circuit board assembly; and
an optically clear adhesive, OCA, layer adhered to the substrate,
wherein the optically clear adhesive, OCA, layer comprises:
an anti-reflective layer, and
an optical adhesive layer,
wherein the anti-reflective layer and the optical adhesive layer are arranged in a stacked configuration.

2. The optical assembly of claim 1, wherein the substrate (504, 606) comprises an electrically conductive trace arranged to electrically connect a micro light emitting diode (406, 506) to the printed circuit board assembly (404, 502, 604).

3. The optical assembly of claim 1 or 2, wherein the substrate (504, 606) comprises a transparent conductive electrode arranged to electrically connect a micro light emitting diode (406, 506) to the printed circuit board assembly (404, 502, 604).

4. The optical assembly of any preceding claim, further comprising:
a virtual imaging distance lens element **characterized by** a corrective prescription.

5. The optical assembly of any preceding claim, further comprising:
a waveguide element to reflect an image generated by a display toward an eye of a user.

6. The optical assembly of any preceding claim, wherein the plurality of micro light emitting diodes, LEDs (406, 506) are located in an interior region of the substrate (504, 606).

7. The optical assembly of any preceding claim, wherein the optically clear adhesive, OCA, layer comprises a near infrared, nIR, anti-reflective coating.

8. A head-mounted display, HMD, device (200, 300, 800), comprising:
a frame;
an image sensor mounted on the frame, the image sensor configured to capture an image representing a physical environment in which the head-mounted display, HMD, device is located; and
the optical assembly of any preceding claim mounted to the frame.

9. A method comprising:
providing a substrate (504, 606) comprising a plurality of conductors laminated in the substrate;
bonding a flexible printed circuit board assembly, PCBA (404, 502, 604) to the substrate (504, 606);
bonding a plurality of micro light emitting diodes, LEDs (406, 506) to the substrate (504, 606);
electrically connecting the micro light emitting diodes to the printed circuit board assembly via the conductors; and
attaching an optically clear adhesive, OCA, layer to the substrate (504, 606), wherein the optically clear adhesive, OCA, layer comprises an anti-reflective layer and an optical adhesive layer arranged in a stacked configuration.

10. The method of claim 9, wherein the plurality of conductors comprise at least one of an electrically conductive trace or a transparent conductive electrode.

11. The method of claim 9 or 10, further comprising providing a virtual imaging distance lens element **characterized by** a corrective prescription.

12. The method of any of claims 9 to 11, further comprising providing a waveguide element to reflect an image generated by a display toward an eye of a user.

13. The method of any of claims 9 to 12, wherein the plurality of micro light emitting diodes, LEDs (406, 506) are located in an interior region of the substrate (504, 606).

14. The method of any of claims 9 to 13, wherein the optically clear adhesive, OCA, layer comprises a near infrared, nIR, anti-reflective coating.

## Patentansprüche

1. Eine optische Anordnung (400, 500, 600), die Folgendes beinhaltet:
ein Substrat (504, 606);
eine flexible Leiterplattenanordnung, PCBA (404, 502, 604), die an das Substrat (504, 606) gebondet ist;
eine Vielzahl von Mikroleuchtdioden, LEDs (406, 506), die an das Substrat (504, 606) gebondet sind;
eine Vielzahl von elektrischen Leitern, die in das Substrat (504, 606) laminiert sind, wobei die Leiter die Mikroleuchtdioden (406, 506) elektrisch mit der Leiterplattenanordnung verbinden; und
eine Schicht aus optisch klarem Klebstoff, OCA-Schicht, die an das Substrat geklebt ist, wobei die Schicht aus optisch klarem Klebstoff, OCA-Schicht, Folgendes beinhaltet:
eine Antireflexionsschicht und
eine Schicht aus optischem Klebstoff,
wobei die Antireflexionsschicht und die Schicht aus optischem Klebstoff in einer gestapelten Konfiguration angeordnet sind.

2. Optische Anordnung gemäß Anspruch 1, wobei das Substrat (504, 606) eine elektrisch leitfähige Spur beinhaltet, die angeordnet ist, um eine Mikroleuchtdiode (406, 506) elektrisch mit der Leiterplattenanordnung (404, 502, 604) zu verbinden.

3. Optische Anordnung gemäß Anspruch 1 oder 2, wobei das Substrat (504, 606) eine transparente leitfähige Elektrode beinhaltet, die angeordnet ist, um eine Mikroleuchtdiode (406, 506) elektrisch mit der Leiterplattenanordnung (404, 502, 604) zu verbinden.

4. Optische Anordnung gemäß einem der vorhergehenden Ansprüche, die ferner Folgendes beinhaltet:
ein Linsenelement für virtuelle Bildgebung, das durch eine Korrekturstärke gekennzeichnet ist.

5. Optische Anordnung gemäß einem der vorhergehenden Ansprüche, die ferner Folgendes beinhaltet:
ein Wellenleiterelement zum Reflektieren eines Bildes, das durch eine Anzeige erzeugt wird, in Richtung eines Auges eines Benutzers.

6. Optische Anordnung gemäß einem der vorhergehenden Ansprüche, wobei sich die Vielzahl von Mikroleuchtdioden, LEDs (406, 506), in einem Innenbereich des Substrats (504, 606) befindet.

7. Optische Anordnung gemäß einem der vorhergehenden Ansprüche, wobei die Schicht aus optisch klarem Klebstoff, OCA-Schicht, eine Antireflexionsbeschichtung für nahes Infrarot, nIR, beinhaltet.

8. Eine Vorrichtung mit einem Head-Mounted-Display, HMD (200, 300, 800), die Folgendes beinhaltet:
einen Rahmen;
einen Bildsensor, der an dem Rahmen montiert ist, wobei der Bildsensor konfiguriert ist, um ein Bild aufzunehmen, das eine physische Umgebung darstellt, in der sich die Vorrichtung mit dem Head-Mounted-Display, HMD, befindet; und
die optische Anordnung gemäß einem der vorhergehenden Ansprüche, die an dem Rahmen montiert ist.

9. Ein Verfahren, das Folgendes beinhaltet:
Bereitstellen eines Substrats (504, 606), das eine Vielzahl von Leitern beinhaltet, die in das Substrat laminiert sind;
Bonden einer flexiblen Leiterplattenanordnung, PCBA (404, 502, 604), an das Substrat (504, 606);
Bonden einer Vielzahl von Mikroleuchtdioden, LEDs (406, 506), an das Substrat (504, 606);
elektrisches Verbinden der Mikroleuchtdioden mit der Leiterplattenanordnung über die Leiter; und
Anbringen einer Schicht aus optisch klarem Klebstoff, OCA-Schicht, an das Substrat (504, 606),
wobei die Schicht aus optisch klarem Klebstoff, OCA-Schicht, eine Antireflexionsschicht und eine Schicht aus optischem Klebstoff, die in einer gestapelten Konfiguration angeordnet sind, beinhaltet.

10. Verfahren gemäß Anspruch 9, wobei die Vielzahl von Leitern mindestens eines von einer elektrisch leitfähigen Spur oder einer transparenten leitfähigen Elektrode beinhaltet.

11. Verfahren gemäß Anspruch 9 oder 10, das ferner das Bereitstellen eines Linsenelements für virtuelle Bildgebung, das durch eine Korrekturstärke gekennzeichnet ist, beinhaltet.

12. Verfahren gemäß einem der Ansprüche 9 bis 11, das ferner das Bereitstellen eines Wellenleiterelements zum Reflektieren eines Bildes, das durch eine Anzeige erzeugt wird, in Richtung eines Auges eines Benutzers beinhaltet.

13. Verfahren gemäß einem der Ansprüche 9 bis 12, wobei sich die Vielzahl von Mikroleuchtdioden, LEDs (406, 506), in einem Innenbereich des Substrats (504, 606) befindet.

14. Verfahren gemäß einem der Ansprüche 9 bis 13, wobei die Schicht aus optisch klarem Klebstoff, OCA-Schicht, eine Antireflexionsbeschichtung für nahes Infrarot, nIR, beinhaltet.

## Revendications

1. Un ensemble optique (400, 500, 600), comprenant :
un substrat (504, 606) ;
un ensemble carte de circuit imprimé, PCBA *(printed circuit board assembly)* (404, 502, 604) souple lié sur le substrat (504, 606) ;
une pluralité de micro-diodes électroluminescentes, LED (406, 506) liées sur le substrat (504, 606) ;
une pluralité de conducteurs électriques stratifiés dans le substrat (504, 606), où les conducteurs connectent électriquement les micro-diodes électroluminescentes (406, 506) à l'ensemble carte de circuit imprimé ; et
une couche d'adhésif optiquement transparente, OCA *(optically clear adhesive),* collée au substrat, où la couche d'adhésif optiquement transparente, OCA, comprend :
une couche antireflet, et
une couche d'adhésif optique,
où la couche antireflet et la couche d'adhésif optique sont agencées selon une configuration empilée.

2. L'ensemble optique de la revendication 1, où le substrat (504, 606) comprend une piste électroconductrice agencée pour connecter électriquement une micro-diode électroluminescente (406, 506) à l'ensemble carte de circuit imprimé (404, 502, 604).

3. L'ensemble optique de la revendication 1 ou de la revendication 2, où le substrat (504, 606) comprend une électrode conductrice transparente agencée pour connecter électriquement une micro-diode électroluminescente (406, 506) à l'ensemble carte de circuit imprimé (404, 502, 604).

4. L'ensemble optique de n'importe quelle revendication précédente, comprenant en outre :
un élément formant lentille à distance d'imagerie virtuelle **caractérisé par** une prescription corrective.

5. L'ensemble optique de n'importe quelle revendication précédente, comprenant en outre :
un élément formant guide d'ondes pour réfléchir une image générée par une unité d'affichage vers un œil d'un utilisateur.

6. L'ensemble optique de n'importe quelle revendication précédente, où la pluralité de micro-diodes électroluminescentes, LED (406, 506) sont situées dans une région intérieure du substrat (504, 606).

7. L'ensemble optique de n'importe quelle revendication précédente, où la couche d'adhésif optiquement transparente, OCA, comprend un revêtement antireflet proche infrarouge, NIR.

8. Un dispositif formant visiocasque, HMD *(head-mounted display),* (200, 300, 800), comprenant :
une monture ;
un capteur d'image monté sur la monture, le capteur d'image étant configuré pour capturer une image représentant un environnement physique dans lequel le dispositif formant visiocasque, HMD, est situé ; et
l'ensemble optique de n'importe quelle revendication précédente monté sur la monture.

9. Un procédé comprenant :
la fourniture d'un substrat (504, 606) comprenant une pluralité de conducteurs stratifiés dans le substrat ;
la liaison d'un ensemble carte de circuit imprimé, PCBA (404, 502, 604) souple sur le substrat (504, 606) ;
la liaison d'une pluralité de micro-diodes électroluminescentes, LED (406, 506) sur le substrat (504, 606) ;
la connexion électrique des micro-diodes électroluminescentes à l'ensemble carte de circuit imprimé par l'intermédiaire des conducteurs ; et
la fixation d'une couche d'adhésif optiquement transparente, OCA, sur le substrat (504, 606),
où la couche d'adhésif optiquement transparente, OCA, comprend une couche antireflet et une couche d'adhésif optique agencées selon une configuration empilée.

10. Le procédé de la revendication 9, où la pluralité de conducteurs comprennent au moins l'une parmi une piste électroconductrice ou une électrode conductrice transparente.

11. Le procédé de la revendication 9 ou de la revendication 10, comprenant en outre la fourniture d'un élément formant lentille à distance d'imagerie virtuelle **caractérisé par** une prescription corrective.

12. Le procédé de n'importe lesquelles des revendications 9 à 11, comprenant en outre la fourniture d'un élément formant guide d'ondes pour réfléchir une image générée par une unité d'affichage vers un œil d'un utilisateur.

13. Le procédé de n'importe lesquelles des revendications 9 à 12, où la pluralité de micro-diodes électroluminescentes, LED (406, 506) sont situées dans une région intérieure du substrat (504, 606).

14. Le procédé de n'importe lesquelles des revendications 9 à 13, où la couche d'adhésif optiquement transparente, OCA, comprend un revêtement antireflet proche infrarouge, NIR.
